# EUROPEAN PATENT SPECIFICATION

(11) **EP 0 679 950 B1**
(45) Date of publication and mention of the grant of the patent: **26.07.2000**
(21) Application number: 95103876.9
(22) Date of filing: 16.03.1995
(51) Int. Cl.: G03F 7/038, G03F 7/021

(54) **Photosensitive lithographic printing plate**
Lichtempfindliche lithographische Druckplatte
Planche d'impression lithographique photosensible

(30) Priority: 25.04.1994 JP 8681994
(43) Date of publication of application: 02.11.1995
(73) Proprietor: FUJI PHOTO FILM CO., LTD., Kanagawa 250-01 (JP)
(72) Inventor: Shiraishi, Yuichi, c/o Fuji Photo Film Co., Ltd., Haibara-gun, Shizuoka (JP); Aoshima, Keitaro, c/o Fuji Photo Film Co., Ltd., Haibara-gun, Shizuoka (JP); Aono, Shoichiro, c/o Fuji Photo Film Co., Ltd., Haibara-gun, Shizuoka (JP)
(74) Representative: Grünecker, Kinkeldey, Stockmair & Schwanhäusser Anwaltssozietät

(56) References cited:
- EP-A- 0 353 873
- EP-A- 0 399 755
- EP-A- 0 443 742
- JP-A- 6 067 417
- US-A- 4 845 009

## Description

### FIELD OF THE INVENTION

The present invention relates to a photosensitive lithographic printing plate and, more precisely, to that having a photo-crosslinking photosensitive layer and having improved sensitivity and press life.

### BACKGROUND OF THE INVENTION

Photo-crosslinking materials that are crosslinked by cyclic addition reaction are well known, and many of them are used as essential components of photosensitive compositions to be used for production of photosensitive lithographic printing plates and so on.

Of such photo-crosslinking materials, photo-crosslinking polymers having a maleimido group at their side chain are not sufficiently photosensitive for practical use. In order to elevate their photosensitivity, generally used are thioxanthones, benzophenone, Michler's ketone, anthraquinones, anthracene, chrysene, p-dinitrobenzene, 2-nitrofluorene, as well as sensitizers described in JP-A-62-294238, JP-A-2-173646, JP-A-2-236552, JP-A-3-54566, and JP-A-6-107718. (The term "JP-A" as used herein means an "unexamined published Japanese patent application".)

In order to ensure the adhesiveness between such photo-crosslinking materials and supports having a water wettable surface to obtain sufficient sensitivity and image intensity and to promote the press life (impression capacity) of printing plates, addition of a diazo resin to the photosensitive layer of the plate has been proposed in, for example, JP-B-5-2227 (the term "JP-B" as used herein means an "examined Japanese patent publication"), JP-A-3-2864, JP-A-3-240061, JP-A-4-274429.

However, the photosensitive lithographic printing plates obtained by these methods have problems in that they do not have sufficiently satisfactory sensitivity and press life.

On the other hand, it is described in JP-A-6-27659 that the sensitivity and the press life of a printing plate is improved by adding a polymerizable compound having two or more ethylenic unsaturated double bonds, such as ethylene glycol diacrylate and pentaerythritol tetraacrylate, to the photosensitive layer containing a photo-crosslinking polymer having a maleimido group at its side chain and a sensitizer.

According to this method, the press life of the printing plate is surely improved. However, this method has various problems in that the photosensitive layer still remains on the non-exposed area after the development of the plate and that ink adheres even to the area which must be inkless during printing, causing scumming on printed matters.

### SUMMARY OF THE INVENTION

Therefore, an object of the present invention is to provide a photosensitive lithographic printing plate having high sensitivity and excellent press life, while maintaining excellent developability and scumming resistance of the photosensitive layer.

This and other objects of the present invention have been attained by a photosensitive lithographic printing plate, which comprises a photosensitive layer comprising (a) a photo-crosslinking polymer having a maleimido group at its side chain(s), (b) a sensitizer, (c) a diazo resin and (d) a polymer having at least one group represented by the following formula (I), on a support having a water wettable (hydrophilic) surface: 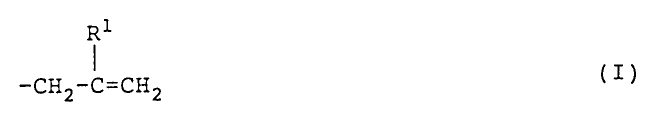 wherein R¹ represents a hydrogen atom or a methyl group.

### DETAILED DESCRIPTION OF THE INVENTION

The present invention is described in detail hereunder.

The photo-crosslinking polymer (a) having a maleimido group at its side chain(s) includes, for example, polymers having a maleimido group represented by the following formula (A) at their side chain(s): 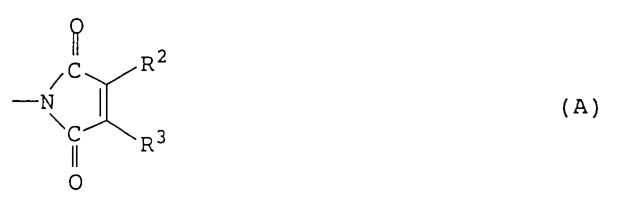 wherein R² and R³ each represents a hydrogen atom, a halogen atom, or an alkyl group; and R² and R³ may be combined with each other to form a 5-membered or 6-membered ring.

The alkyl group for R² and R³ is preferably an alkyl group having from 1 to 4 carbon atoms, especially preferably a methyl group. Also preferably, R² and R³ are combined with each other to form a 6-membered ring. The halogen atom for R² and R³ is preferably a chlorine atom, a bromine atom or an iodine atom.

These polymers are described in, for example, U.S. Patent 4,079,041 (corresponding to JP-A-52-988); West German Patent 2,626,769; European Patents 21,019 and 3,552; Die Angewandte Mackromolekulare Chemi, 115 (1983), pp. 163-181; JP-A-49-128991 to JP-A-49-128993, JP-A-50-5376 to JP-A-50-5380, JP-A-53-5298 to JP-A-53-5300, JP-A-50-50107, JP-A-51-47940, JP-A-52-13907, JP-A-50-45076, JP-A-52-121700, JP-A-50-10844, JP-A-50-45087, JP-A-58-43951; West German Patents 2,349,948 and 2,616,276.

Of these polymers, those having, at their side chains, two or more maleimido groups on average in one molecule and having a mean molecular weight of 1000 or more are preferably used in the present invention. Such polymers can be produced, for example, from monomers represented by the following formulae (B) to (D): 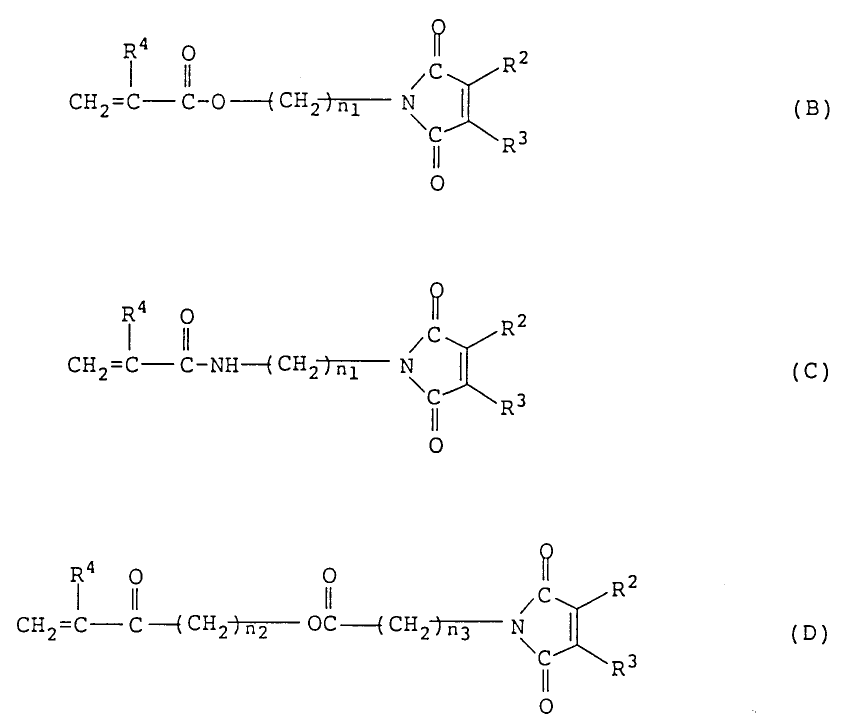 wherein R² and R³ have the same meaning as those in formula (A); R⁴ represents a hydrogen atom or a methyl group; n₁, n₂ and n₃ each represents an integer of 1 or more, preferably from 1 to 6.

The photosensitive lithographic printing plate containing any of these polymers is preferably developed with an aqueous alkaline developer substantially not containing an organic solvent, in view of the environmental safety. Therefore, it is preferable that these polymers are soluble in or swellable with aqueous alkalis. Accordingly, it is preferable that monomers having a maleimido group at its side chain are copolymerized with monomers having an alkali-soluble group to obtain these polymers.

As the alkali-soluble group, preferred are acid groups having a pKa of 14 or less. Specific examples of such monomers having an alkali-soluble group include vinyl monomers having a carboxyl group, such as acrylic acid, methacrylic acid, maleic acid, itaconic acid; vinyl monomers having a -CONHSO₂- group, such as those represented by the following formula (E); vinyl monomers having an -SO₂NH- group, such as those represented by the following formula (F); vinyl monomers having a phenolic hydroxyl group, such as those represented by the following formula (G); vinyl monomers having a phosphoric acid group or a phosphonic acid group, such as those represented by the following formula (H); as well as maleic anhydride, and itaconic anhydride.

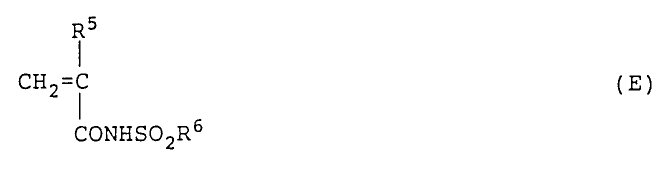

In formula (E), R⁵ represents a hydrogen atom or a methyl group; and R⁶ represents a hydrocarbon group having from 1 to 12 carbon atoms which may be substituted.

R⁶ is preferably a methyl group, a phenyl group or a tolyl group.

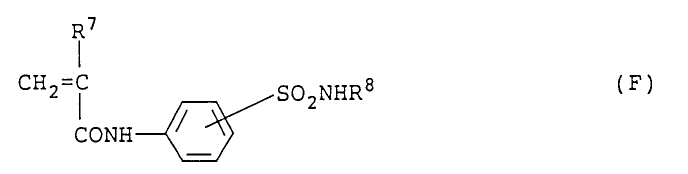

In formula (F), R⁷ represents a hydrogen atom or a methyl group; R⁸ represents a hydrogen atom, or a hydrocarbon group having from 1 to 12 carbon atoms which may be substituted.

R⁸ is preferably a hydrogen atom, a methyl group, a phenyl group or a tolyl group.

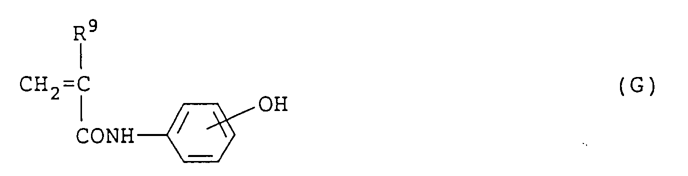

In formula (G), R⁹ represents a hydrogen atom or a methyl group.

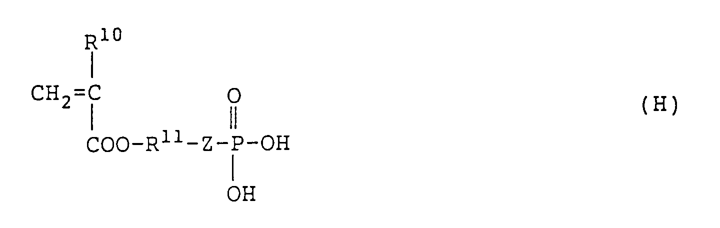

In formula (H), R¹⁰ represents a hydrogen atom or a methyl group; R¹¹ represents a hydrocarbon linkage group having from 1 to 12 carbon atoms; Z represents an oxygen atom or a single bond.

R¹¹ is preferably an alkylene group having from 1 to 6 carbon atoms or a phenylene group.

The alkali-soluble group-having monomer and the maleimido group-having monomer are copolymerized at a ratio of from 10/90 to 70/30 by mol, preferably from 20/80 to 60/40 by mol, to easily give a photo-crosslinking polymer (a) for use in the present invention. The polymer (a) has preferably an acid value of from 30 to 500, especially preferably from 50 to 300.

Of such photo-crosslinking polymers, especially useful are copolymers composed of an N-[2-methacryloyloxy)alkyl]-2,3-dimethylmaleimide and methacrylic acid or acrylic acid, such as those described in Die Angewandte Mackromolekulare Chemi, 128 (1984), pp. 71-91. In producing these copolymers, vinyl monomers may be additionally copolymerized, as the third component, to easily give polynary copolymers in accordance with the object. For instance, alkyl methacrylates or alkyl acrylates of which homopolymers have a glass transition temperature not higher than room temperature can be copolymerized as the third component to give flexible copolymers.

The photo-crosslinking polymer (a) for use in the present invention has preferably a weight average molecular weight of 1000 or more, more preferably from 10,000 to 500,000, and even more preferably from 20,000 to 300,000.

As the sensitizer (b), preferred is a triplet sensitizer having an absorption peak for ensuring sufficient light absorption at 300 nm or more.

Examples of such sensitizer include benzophenone derivatives, benzanthrone derivatives, quinones, aromatic nitro compounds, naphthothiazoline derivatives, benzothiazoline derivatives, thioxanthones, naphthothiazole derivatives, ketocoumarin compounds, benzothiazole derivatives, naphthofranone compounds, pyrylium salts, and thiapyrylium salts.

Specific examples thereof include Michler's ketone, N,N'-diethylaminobenzophenone, benzanthrone, (3-methyl-1,3-diazo-1,9-benz)anthronepicramide, 5-nitroacenaphthene, 2-chlorothioxanthone, 2-isopropylthioxanthone, dimethylthioxanthone, methylthioxanthon-1-ethyl carboxylate, 2-nitrofluorenone, 2-dibenzoylmethylene-3-methylnaphthothiazoline, 3,3-carbonyl-bis(7-diethylaminocoumarin), 2,4,6-triphenylthiapyrylium perchlorate, 2-(p-chlorobenzoyl)naphthothiazole, as well as sensitizers described in JP-B-45-8832, JP-A-52-129791, JP-A-62-294238, JP-A-2-173646, JP-A-2-131236, European Patent 368,327, JP-A-2-236552, JP-A-3-54566, and JP-A-6-107718.

Of these, preferred are the sensitizers described in JP-A-2-236552, JP-A-3-54566, and JP-A-6-107718; and especially preferred are the sensitizers having one or more of -COOH, -NHSO₂R²⁰, -CONHCOR²⁰ and/or -CONHSO₂R²⁰ (where R²⁰ represents an alkyl group, an aromatic group or an alkyl-aromatic group) as an alkali-soluble group in one molecule, described in JP-A-6-107718.

The amount of the sensitizer to be in the photosensitive layer is from 1 to 20% by weight, preferably from 2 to 15% by weight, and more preferably from 3 to 10% by weight, of the total amount of the compositions in the photosensitive layer.

Examples of the diazo resin (c) include cocondensates composed of aromatic diazonium compounds and aldehydes. Specific examples thereof include the diazo resins described in JP-B-49-48001, JP-B-50-7481, JP-B-5-2227, JP-A-3-2864, JP-A-3-240061, and JP-A-4-274429.

Of these, preferred are diazo resins having a carboxyl group in the molecule, for example, diazo resins obtained by co-condensation with aromatic compounds having at least one carboxyl group, such as those described in JP-A-3-240061, and diazo resins obtained by condensation with aldehydes having a carboxyl group, such as those described in JP-A-3-2864.

The amount of the diazo resin to be in the photosensitive layer is from 0.1 to 30% by weight, preferably from 0.5 to 10% by weight, and more preferably from 1 to 5% by weight of the total amount of the compositions in the photosensitive layer.

The polymer (d) for use in the present invention is characterized in having a group represented by the above-described formula (I).

The above-mentioned polymer is known in JP-B-3-63740, U.S. Patents 3,376,138, 3,556,793. In the known examples, however, the polymer is employed alone or along with a photo-polymerizable composition comprising a photo-polymerization initiator and a monomer having an ethylenically unsaturated double bond, for the purpose of reducing the variation in the sensitivity of the photosensitive layer which depends on the ambient temperature during exposure. Therefore, the known technical idea of using the polymer is clearly different from the technical idea of the present invention of using a photosensitive composition comprising the photo-crosslinking polymer having a maleimido group at the side chain (a), the sensitizer (b) and the diazo resin (c) along with the polymer (d).

The above-mentioned polymer (d) is obtained by addition polymerization of monomer having the group represented by the above-mentioned formula (I) and an ethylenically unsaturated bond that are more reactive for addition polymerization than the group represented by formula (I). Of such monomers, preferred are those represented by the following formula (II):

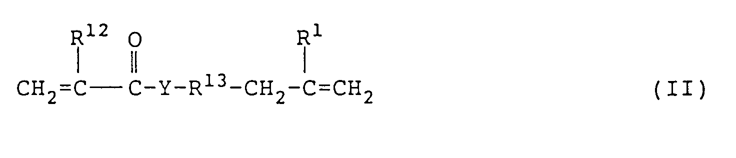

In formula (II), R¹ and R¹² each represents a hydrogen atom or a methyl group; Y represents an oxygen atom, a sulfur atom, -NH-, or -N(R¹⁴)- (where R¹⁴ represents an alkyl group); R¹³ represents a single bond, -(CH₂)ₙ-, -(C(R¹⁵)H-C(R¹⁶)H-O)ₙ- or -(CH₂CH₂CH₂O)ₙ- (where R¹⁵ and R¹⁶ each represents a hydrogen atom or a methyl group; and n represents an integer of from 1 to 6).

Examples of the monomer represented by formula (II) include allyl (meth)acrylate, 2-methyl-2-propenyl (meth)acrylate, 3-butenyl (methacrylate), 3-methyl-3-butenyl (meth)acrylate, 4-pentenyl (meth)acrylate, 4-methyl-4-pentenyl (meth)acrylate, 5-hexenyl (meth)-acrylate, 5-methyl-5-hexenyl (meth)acrylate, 7-octenyl (meth)acrylate, 7-methyl-7-octenyl (meth)acrylate, ethylene glycol monoallyl ether (meth)acrylate, ethylene glycol mono(2-methyl-2-propenyl) ether (meth)acrylate, diethylene glycol monoallyl ether (meth)acrylate, diethylene glycol mono(2-methyl-2-propenyl) ether (meth)acrylate, triethylene glycol monoallyl ether (meth)acrylate, triethylene glycol mono(2-methyl-2-propenyl) ether (meth)-acrylate, 2,3-butylene glycol monoallyl ether (meth)-acrylate, trimethylene glycol monoallyl ether (meth)-acrylate, trimethylene glycol mono(2-methyl-2-propenyl) ether (meth)acrylate, bis(trimethylene glycol) monoallyl ether (meth)acrylate, bis(trimethylene glycol) mono(2-methyl-2-propenyl) ether (meth)acrylate, and (meth)acrylamides and N-alkyl(meth)acrylamides having the same substituents as those in the above-mentioned compounds.

The above-mentioned polymer (d) is preferably soluble in or swellable with aqueous alkalis, like the polymers having a maleimido group at the side chain. Therefore, the polymer (d) is preferably a copolymer composed of a monomer having the unsaturated group represented by formula (I) and a monomer having an alkali-soluble group.

Examples of the monomer having an alkali-soluble group include vinyl monomers having a carboxyl group, such as acrylic acid, methacrylic acid, maleic acid, and itaconic acid, vinyl monomers of the above-mentioned formulae (E), (F), (G) and (H), as well as maleic anhydride, a itaconic anhydride.

The ratio of the unsaturated group in formula (I) to the alkali-soluble group in the polymer (d) is not defined but is preferably from 20/80 to 95/5 by mol, more preferably from 40/60 to 85/15 by mol.

To obtain the polymer (d) by copolymerization, other comonomers may be added to the copolymerization system, as the third component. Examples of such comonomers include alkyl acrylates, alkyl methacrylates, 2-hydroxyethyl methacrylate, and acrylonitrile.

The polymer (d) thus obtained preferably has an acid value of from 30 to 500, more preferably from 50 to 350. The polymer (d) preferably has a weight average molecular weight of from 5,000 to 300,000, more preferably from 10,000 to 200,000.

Next, examples of producing typical examples of the polymer (d) for use in the present invention will be mentioned below.

### Production Example 1

Propylene glycol monomethyl ether of 500 ml as a reaction solvent were put into a 2-liter four-neck flask equipped with a stirring shaft, stirring blades, a reflux condenser, a dropping funnel and a thermometer, and heated at 70°C, while substituting the atmosphere in the flask by nitrogen. A solution prepared by dissolving 56.7 g of allyl methacrylate, 25.8 g of methacrylic acid, and 4.66 g of 2,2'-azobis(2,4-dimethylvaleronitrile as a polymerization initiator in 500 ml of propylene glycol monomethyl ether was put into the dropping funnel, and this solution was added dropwise into the flask while stirring for two hours.

After the dropwise addition, the mixture in the flask was stirred at 70°C for 5 hours to finish the reaction. After the reaction under heating, the reaction mixture was poured into 10 liters of water to form a precipitate therein. This was dried in vacuum to obtain 66 g (yield: 80%) of a copolymer (Polymer 1 of the invention). This polymer had a weight average molecular weight of 30,000.

### Production Example 2

The same process as in Production Example 1 was repeated, except that 75.0 g of N-allylmethacrylamide were used in place of allyl methacrylate and that the amount of methacrylic acid was changed to 17.2 g, to obtain a copolymer (Polymer 2 of the invention). This polymer had a weight average molecular weight of 65,000.

### Production Example 3

The same process as in Production Example 1 was repeated, except that 68.0 g of (ethylene glycol monoallyl ether) methacrylate were used in place of allyl methacrylate and that 8.6 g of acrylic acid were used in place of methacrylic acid, to obtain a copolymer (Polymer 3 of the invention). This polymer had a weight average molecular weight of 20,000.

The mixing ratio of the above-mentioned polymer (d) to the polymer (a) having a maleimido group at its side chain in the photosensitive layer of the present invention is not defined but is preferably from 1/99 to 90/10 by weight, more preferably from 10/90 to 75/25 by weight. The total amount of these two polymers used in the photosensitive layer is from 10 to 99% by weight, preferably from 30 to 99% by weight, and more preferably from 50 to 90% by weight, of the total amount of the compositions in the photosensitive layer.

The photosensitive layer of the present invention may contain a binder, if desired. The binder is generally selected from organic linear polymers. Examples of such binder include known alkali-soluble polymers, such as phenol-formaldehyde resins, cresol-formaldehyde resins, phenol-modified xylene resins, polyhydroxystyrenes, polyhalogenated hydroxystyrenes, carboxyl group-containing epoxy resins, polyacetal resins, acrylic resins, methacrylic resins, and carboxyl group-containing polyurethane resins. The amount of such an alkali-soluble polymer used in the photosensitive layer is 50% by weight or less of the total amount of the compositions in the photosensitive layer.

The photosensitive layer of the present invention may further contain other various additives, if desired.

For instance, polyfunctional monomers having two or more radical-polymerizable, ethylenically double bonds in one molecule can be added thereto. Examples of such monomers include ethylene glycol di(meth)acrylate, di-ethylene glycol di(meth)acrylate, polyethylene glycol di-(meth)acrylate, hexanediol di(meth)acrylate, trimethylolethane tri(meth)acrylate, trimethylolpropane tri(meth)acrylate, and tri-, tetra- or hexa(meth)acrylates of pentaerythritol or dipentaerythritol. The amount of the polyfunctional monomer used in the photosensitive layer is 10% by weight or less of the total amount of the compositions in the photosensitive layer.

To color the photosensitive layer, it is preferred that the photosensitive layer contains various dyes or pigments, such as diphenylmethane dyes, triphenylmethane dyes, thiazine dyes, oxazine dyes, xanthone dyes, anthraquinone dyes, iminonaphthoquinone dyes, azomethine dyes, azo dyes, titanium oxide, iron oxide, carbon black, phthalocyanine pigments, and azo pigments. In addition, the photosensitive layer may also contain, as a printing-out agent, a combination of a photo acid-generating agent or a photo-oxidizing agent, such as trihalomethyl group-containing compounds, diazo monomers, sulfonium salts and iodonium salts, and a pH indicator and a leuco dye.

The photosensitive layer of the present invention may contain a plasticizer. Examples of the plasticizer include dialkyl phthalate plasticizers, such as dibutyl phthalate and dihexyl phthalate, oligoethylene glycol alkyl ester plasticizers, and phosphate plasticizers. In addition, the layer may further contain, as a stabilizer for the diazo resin therein, various acid compounds, and, as a development accelerator, acid group-containing compounds soluble in aqueous alkalis.

Moreover, it is also possible to add to the photosensitive layer of the present invention a ink receptivity agent, a surfactant, a fluorine compound, and a silica compound, thereby modifying the properties of the surface of the photosensitive layer.

It is preferred that the photosensitive layer contains a thermal polymerization inhibitor and an anti-oxidant. Examples thereof include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), and 2-mercaptobenzimidazole.

To form the photosensitive layer of the photosensitive lithographic printing plate of the present invention, the above-mentioned components are dissolved in a solvent which can dissolve them and the resulting solution is coated on a support. Example of the solvent include methanol, ethanol, isopropyl alcohol, n-butyl alcohol, t-butyl alcohol, ethylene dichloride, cyclohexanone, acetone, methyl ethyl ketone, ethylene glycol, ethylene glycol monomethyl ether, ethylene glycol monoethyl ether, 2-methoxyethyl acetate, 1-methoxy-2-propanol, 1-methoxy-2-propyl acetate, N,N-dimethylformamide, tetrahydrofuran, dioxane, dimethylsulfoxide, ethyl acetate, methyl lactate, and ethyl lactate. These solvents are used alone or as mixed solvents comprising two or more of them.

A small amount of water may be added to the solvent or mixed solvents.

The concentration of the above-mentioned components (as a solid content) in the solution containing them is from 1 to 50% by weight.

The photosensitive solution comprising the above-mentioned components dissolved in a (mixed) solvent is coated on a support and dried thereon preferably at 50°C to 120°C. With regard to the drying process, the solution coated may be first pre-dried at low temperatures and then dried at high temperatures or, alternatively, this may be directly dried at high temperatures if the solvent to be used and the concentration of the solution to be coated are selected suitably.

The coating amount of the photosensitive layer after drying is preferably from 0.1 g/m² to 10 g/m², more preferably from 0.5 g/m² to 5 g/m².

In the present invention, if desired, an inter-layer may be provided so as to elevate the adhesiveness between the support and the photosensitive layer, or so as to completely remove the photosensitive layer after development, or so as to prevent halation. In order to elevate the adhesiveness between them, in general, the interlayer to be provided shall comprise a diazo resin, a phosphoric acid compound such as that capable of adsorbing to aluminium, a silane coupling agent, and so on. The interlayer to be provided so as to completely remove the photosensitive layer after development shall comprise, in general, a polymer highly soluble in developers or a water-soluble polymer. For anti-halation, the interlayer generally comprises a dye or a UV absorbent. The thickness of the interlayer is not defined but must be such that the interlayer can be reacted with the upper photosensitive layer to be uniformly bonded thereto by exposure. In general, the amount of the interlayer to be provided may be approximately from 1 to 100 mg/m², especially preferably from 5 to 40 g/m², as a dry solid amount.

The interlayer may comprise the same co-condensed diazo resin and photo-crosslinking polymer as those used in the photosensitive layer. The amount of these in the interlayer may be from 5 to 100% by weight, preferably from 10 to 100% by weight, of weight of the interlayer.

The interlayer may contain a sensitizer, a diazo stabilizer, a polymer binder, an anti-halation agent, a surfactant and other various additives, if desired.

To form the interlayer, the above-mentioned compounds are dissolved in a solvent at any desired concentration, and the resulting solution is coated on a support or a support is immersed in the solution, and thereafter the thus-coated support is dried.

The surface of the photosensitive layer formed in the manner as mentioned above is preferably matted so as to shorten the time for vacuum suction and to prevent lack of sharpness in printing during contact exposure by using a vacuum printing frame. Concretely, examples of method of matting the surface include a method of forming a matting layer as described in JP-A-50-125805, JP-A-58-182636, JP-B-57-6582 and a method of heat-fusing a solid powder as described in JP-B-62-62337.

The support having a hydrophilic support which is used in the present invention is preferably a sheet having dimension stability. Such a dimension-stable sheet includes supports that have heretofore been used for producing conventional printing plates, and any and every such conventional support can be employed in the present invention. Examples of such supports include paper; plastic-laminated paper (e.g., polyethylene, polypropylene, polystyrene); sheets of metals such as aluminium (including aluminium alloys), zinc, and copper; films of plastics such as cellulose diacetate, cellulose triacetate, cellulose propionate, cellulose acetate, cellulose acetate butyrate, cellulose nitrate, polyethylene terephthalate, polyethylene, polystyrene, polypropylene, polycarbonate, and polyvinyl acetal; paper or plastic films coated with the above-mentioned metals by lamination or vapor deposition. Of these supports, an aluminium sheet is preferred, since this has extremely high dimension stability, this is low-priced, and the adhesion of this to the photosensitive layer of the present invention is especially good. In addition, also preferred is a composite sheet composed of an aluminium sheet on a polyethylene terephthalate film.

The metal support, especially the aluminium support for use in the present invention is preferably surface-processed with sand-graining or anodic oxidation.

So as to elevate the hydrophilic property of the surface of the support, it is preferred to immerse the support in an aqueous solution of sodium silicate, potassium fluorozirconate, or phosphates. Aluminium supports that have been sand-grained and then immersed in an aqueous solution of sodium silicate, such as those described in U.S. Patent 2,714,066, as well as aluminium supports that have been processed with anodic oxidation and then immersed in an aqueous solution of alkali metal silicates, such as those described in JP-B-47-5125, are preferably employed in the present invention.

Silicate-electrodeposition such as those described in U.S. Patent 3,658,662, are also effectively used in the present invention. In addition, surface processing combining a support processed with electrolytic graining with the above-described anodic oxidation processing and sodium silicate processing, such as those described in JP-B-46-27481, JP-A-52-58602 and JP-A-52-30503, are also usable in the present invention.

Supports processed with brush-graining, electrolytic graining, anodic oxidation and processing with sodium silicate in order, such as those described in JP-A-56-28893, are also preferably used in the present invention. To favorably use these in the present invention, the thus-processed supports may be coated with a subbing layer comprising a water-soluble resin such as a polyvinylphosphonic acid, a polymer or copolymer having a sulfonic acid group at its side chain, and a polyacrylic acid. Further, the supports disclosed in JP-A-2-23348 and JP-A-4-43559 are also preferably used in the present invention.

The water wettability processing of the support for use in the present invention is effected not only so as to make the surface of the support water wettable but also so as to prevent any harmful reaction between the surface and the upper photosensitive layer and to improve the adhesiveness between them.

The photosensitive lithographic printing plate of the present invention is imagewise exposed, using a light source that is rich in ultraviolet rays, such as a metal halide lamp and a high-pressure mercury lamp, and then processed with a developer to remove the non-exposed area of the thus-exposed layer, and finally a desensitizing liquid gum is coated over the surface of the plate to obtain a lithographic printing plate.

Examples of the developer applied to the exposed photosensitive layer of the present invention include aqueous solutions of inorganic alkalis such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate and aqueous ammonia, as well as aqueous solutions of organic amine compounds such as mono-, di-and tri-ethanolamines. The concentration of the developing agent in the developer is from 0.1 to 10% by weight, preferably from 0.5 to 5% by weight.

The aqueous alkaline solutions may contain a surfactant and an organic solvent such as alcohols, if desired. As the organic solvent, preferred are benzyl alcohol, 2-phenoxyethanol, 2-butoxyethanol, and n-propyl alcohol. As the surfactant, usable are anionic surfactants such as alkylnaphthalenesulfonates and sodium laurylsulfate. In addition to these, the solutions may also contain a diazo solubilizer, and a reducing substance such as sulfites, methylresorcin, and pyrazolone compounds, etc. Further, the solutions may contain other various additives such as those described in U.S. Patents 3,475,171 and 3,615,480. The developers described in JP-A-50-26601, JP-B-56-39464 and JP-B-56-42860 are also preferably used for developing the photosensitive lithographic printing plate of the present invention.

The organic solvents, if contained in the developers for use in the present invention, often cause various problems. If they are toxic or give an offensive odor, they cause sanitary problems. If they are flammable or explosive, they cause problems against safety. If they foam, they cause problems to make the operation difficult. The waste liquids often cause environmental pollution. If they are high-priced, they cause problems about the production costs. In view of these, it is preferred to use developers containing substantially no organic solvent.

The term "containing substantially no organic solvent" as referred to herein means that the developer does not contain an organic solvent to such a degree that the organic solvent therein is inconvenient in view of the above-mentioned various problems about environmental sanitation, safety, and operability. Concretely, it means that the developer contains an organic solvent in an amount of 2% by weight or less, preferably 1% by weight or less.

Examples of such an aqueous alkaline developer containing substantially no organic solvent are described in, for example, JP-A-59-84241 and JP-A-57-192952, in which the developer is used for developing an imagewise-exposed positive lithographic printing plate.

Needless-to-say, the photosensitive lithographic printing plate using the above-mentioned components of the present invention can be processed according to the photomechanical processes described in JP-A-54-8002, JP-A-55-115045, and JP-A-59-58431. Concretely, after developed, the plate may be subjected to desensitizing processing after rinsing, may be subjected to desensitizing processing without being rinsed, may be subjected to processing with an aqueous solution containing an acid, or may be subjected to desensitizing processing after processing with an aqueous solution containing an acid. During the step for developing the photosensitive lithographic printing plate of this kind with an automatic developing machine, the aqueous alkaline solution is consumed and the alkali content in the solution is thereby decreased, depending on the amount of the plate being processed, or the alkali content in the solution is decreased due to air and the processing ability of the solution is thereby lowered while the automatic developing machine is run for a long period of time. In such cases, the replenishers described in JP-A-54-62004, JP-A-55-22759, JP-A-55-115039, JP-A-56-12645, JP-A-58-95349, JP-A-64-21451, JP-A-1-180548, and JP-A-2-3065 may be added to the machine in accordance with the replenishing methods described in them to thereby recover the processing ability of the developer.

It is preferred to use the automatic developing machines described in JP-A-2-7054 and JP-A-2-32356 to carry out the above-mentioned photomechanical processes. As the desensitizing gum material which is optionally coated on the plate at the final step in the photomechanical process, those described in JP-B-62-16834, JP-B-62-25118, JP-B-63-52600, JP-A-62-7595, JP-A-62-11693, and JP-A-62-83194 are preferably used.

After developed, deletion processing, rinsing processing and desensitizing processing may be carried out, if desired. In order to enhance the mechanical strength of the image area of the processed plate, the plate may be subjected to post-exposure or burning in processing.

The present invention will be described in more detail by means of the following examples, however, it should be understood that the present invention is not to be deemed to be limited thereto. Unless otherwise specifically indicated, all "%" in the examples is by weight.

### Example 1

The surface of a lS aluminium sheet having a thickness of 0.24 mm was well sand-grained with a nylon brush and an aqueous suspension of 400-mesh pumice stone, and then well washed with water. This was etched by immersing it in an aqueous solution of a 10% sodium hydroxide solution at 70°C for 60 seconds, then rinsed in running water, neutralized and washed with 20% nitric acid, and electrolyzed in an aqueous solution of 1% nitric acid, using a sine-curve alternate current of V_{A} = 12.7 V and V_{C} = 9.1 V, at a quantity of anodic electricity of 170 C/dm², thereby roughening the surface of the plate. Subsequently, this was desmatted by dipping it in an aqueous solution of 30% sulfuric acid at 55°C for 2 minutes, and then subjected to anodic oxidation in an aqueous solution of 7% sulfuric acid, the amount of aluminium oxide thus coated being 1.8 g/m². Afterwards, this was immersed in an aqueous solution of a 3% sodium silicate solution at 70°C for one minute, then rinsed and dried. The thus-processed aluminium sheet was coated with the photosensitive solution (I) mentioned below at a dry weight of 1.5 g/m², using a foiler, and dried at 80°C for 2 minutes.

The thus-obtained photosensitive lithographic printing plate is referred to as printing plate [A].

### Photosensitive Solution (I):

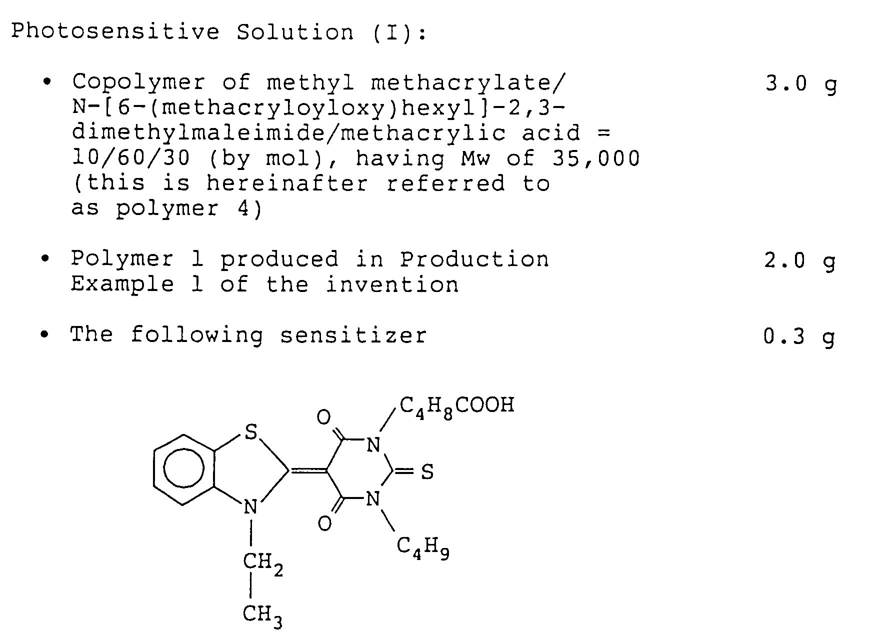

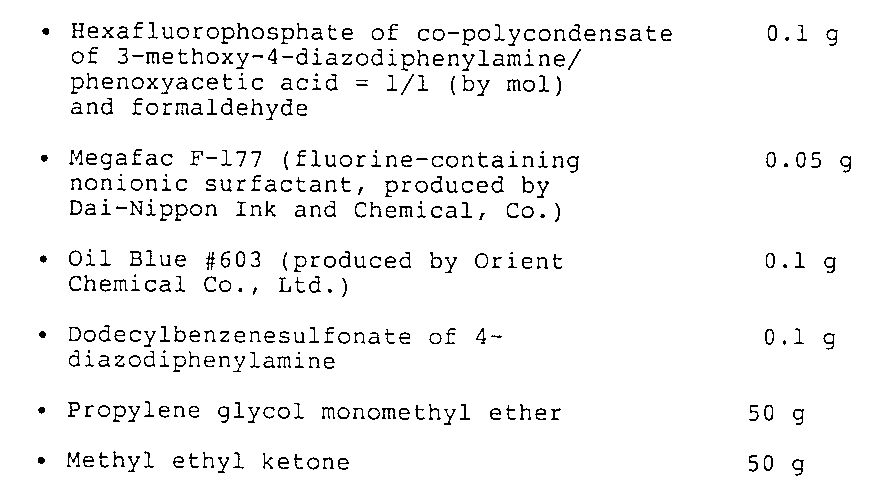

### Comparative Example 1

Photosensitive lithographic printing plate [B] was prepared in the same manner as in Example 1, except that polymer 1 was not added to the above-mentioned photosensitive solution (I) but the amount of polymer 4 therein was changed to 5.0 g.

### Comparative Example 2

Photosensitive lithographic printing plate [C] was prepared in the same manner as in Example 1, except that 2.0 g of pentaerythritol tetraacrylate were added to the above-mentioned photosensitive solution (I) in place of 2.0 g of polymer 1.

On each of the thus-obtained photosensitive lithographic printing plates [A], [B] and [C], laid was a step-wedge (having a difference of 0.15 in the density between the adjacent steps and having a maximum density at the 15th step) and a negative dot film. These plates were then exposed for 50 counts, using a printer, FT26V2UPNS (light source: 2 KW metal halide lamp) (produced by Nu Arc Company in USA). The thus-exposed plates were immersed in the following developer (I) at 25°C for 20 seconds, then lightly rubbed with developing pat, rinsed and processed with the following desensitizing solution to desensitize them. Thus, lithographic printing plates were produced.

### Developer (I):

| | |
|---|---|
| · Potassium silicate having [SiO₂]/[K₂O] of 1.2 by mol | 32 g |
| · Sodium ethylenediaminetetraacetate | 1 g |
| · Water | 967 g |

### Desensitizing Solution:

| | |
|---|---|
| · Arabic gum | 5 g |
| · White dextrin | 30 g |
| · Ethylene glycol | 10 g |
| · Phosphoric acid | 3 g |
| · Water | 952 g |

Using an SOR printer (produced by Hidelberger Druckmaschinen Aktiengesellschaft) and these printing plates, high-quality papers were printed with commercial ink.

The properties of the printing plates are shown in Table 1.

**Table 1**

| | Printing plate [A] | Printing plate [B] | Printing plate [C] |
|---|---|---|---|
| Developability | Good | Good | Remained |
| Maximum step in stepwedge | 11th step | 8th step | 8th step |
| Scumming in prints | No | No | Scumming |
| Press life | Up to 50,000 prints | Up to 25,000 prints | Up to 35,000 prints |

The properties of the printing plates shown in Table 1 and Tables 2 and 3 shown below were evaluated as follows:
- To evaluate the "developability", the surface of each developed plate was checked as to whether or not the photosensitive layer remained. "Good" means that the developability was good; while "remained" means that the photosensitive layer remained on the developed surface.
- "Maximum step in stepwedge" means the largest step number at which the developed image remained on the stepwedge. The number larger by two steps means that the sensitivity is larger by two times.
- "Scumming in prints" means that the area in prints that should not be inked was scummed with ink.
- "Press life" means the largest number of satisfactory prints obtained without having no printing failure. Printing failure is such that the area in prints that should be inked is not inked well. The larger the number of such prints, the better the press life.

### Comparative Example 3

Photosensitive lithographic printing plate [D] was prepared in the same manner as in Example 1, except that polymer 4 was not added to the above-mentioned photosensitive liquid (I) but the amount of polymer 1 therein was changed to 5.0 g.

This printing plate [D] was exposed and developed in the same manner as in Example 1, but no image was formed. Accordingly, it is known that polymer 1 cannot be photo-crosslinked by itself.

### Example 2

The following photosensitive solution (II) was prepared. This was coated and dried on the same support as that employed in Example 1 to obtain photosensitive lithographic printing plate [E].

### Photosensitive Solution (II):

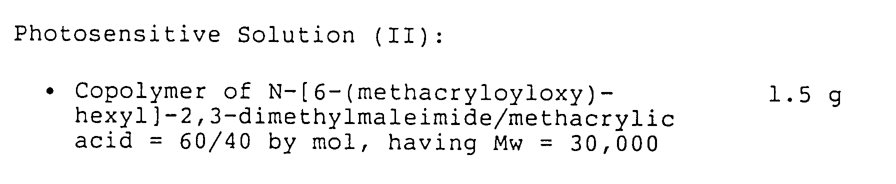

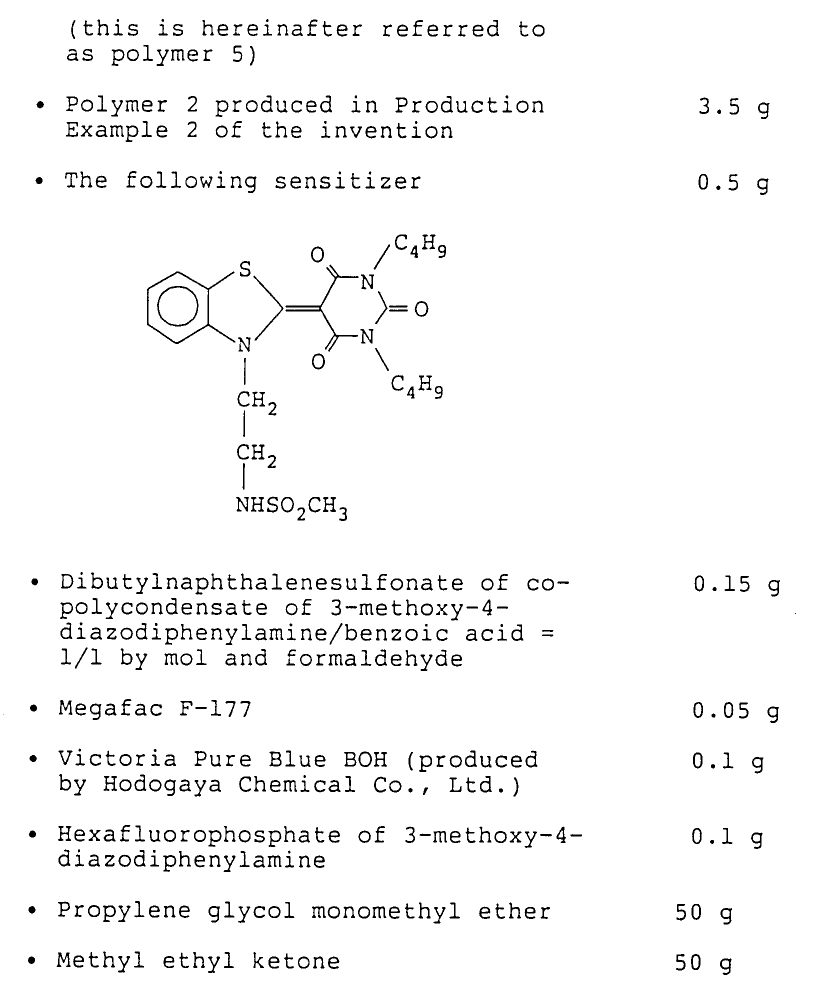

### Comparative Example 4

Photosensitive lithographic printing plate [F] was prepared in the same manner as in Example 2, except that polymer 2 was not added to the above-mentioned photosensitive solution (II) but the amount of polymer 5 therein was changed to 5.0 g.

The thus-obtained photosensitive lithographic printing plates [E] and [F] were exposed in the same manner as in Example 1, then immersed in the following developer (II) at 25°C for 20 seconds, lightly rubbed with developing pad, rinsed, and then subjected to desensitizing processing in the same manner as in Example 1. Thus, lithographic printing plates were obtained. Using these, papers were printed.

### Developer (II):

| | |
|---|---|
| · Potassium silicate having SiO₂/K₂O by mol of about 0.8 | 60 g |
| · Water | 940 g |

The results obtained are shown in Table 2.

**Table 2**

| | Printing plate [E] | Printing plate [F] |
|---|---|---|
| Developability | Good | Good |
| Maximum step in stepwedge | 10th step | 8th step |
| Scumming in prints | No | No |
| Press life | Up to 45,000 prints | Up to 20,000 prints |

### Example 3

The following photosensitive solution (III) was prepared. This was coated and dried on the same support as that employed in Example 1, to obtain photosensitive lithographic printing plate [G].

### Photosensitive Solution (III):

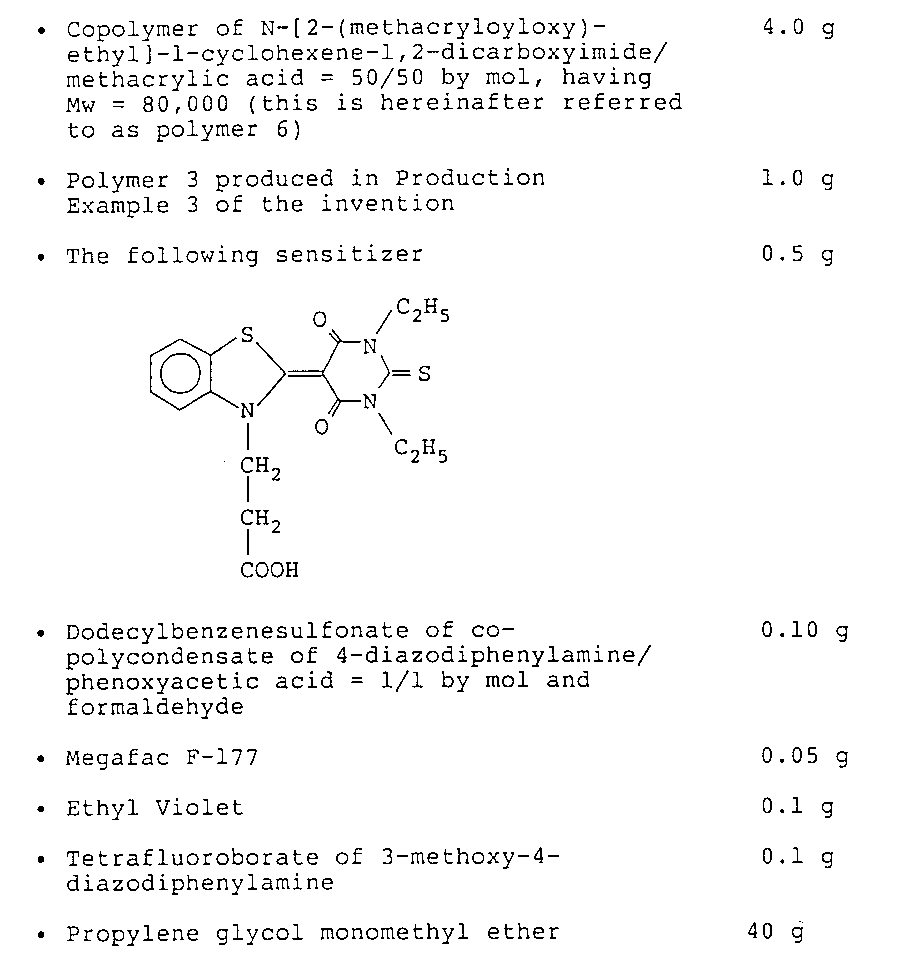

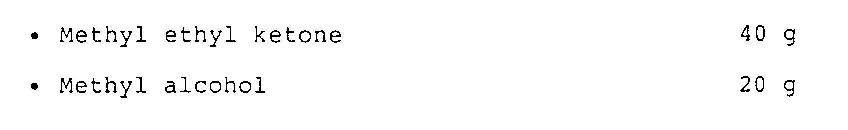

### Comparative Example 5

Photosensitive lithographic printing plate [H] was prepared in the same manner as in Example 3, except that polymer 3 was not added to the above-mentioned photosensitive liquid (III) but the amount of polymer 6 therein was changed to 5.0 g.

The thus-obtained photosensitive lithographic printing plates [G] and [H] were exposed, developed and subjected to desensitizing processing, in the same manner as in Example 1. Thus, lithographic plates were obtained. Using these, papers were printed. The results obtained are shown in Table 3.

**Table 3**

| | Printing plate [G] | Printing plate [H] |
|---|---|---|
| Developability | Good | Good |
| Maximum step in stepwedge | 11th step | 9th step |
| Scumming in prints | No | No |
| Press life | Up to 40,000 prints | Up to 20,000 prints |

The photosensitive lithographic printing plate of the present invention has high sensitivity and excellent press life, while maintaining the excellent developability and scumming resistance of the photosensitive layer.

## Claims

1. A photosensitive lithographic printing plate, which comprises a photosensitive layer comprising (a) a photo-crosslinking polymer having a maleimido group at its side chain, (b) a sensitizer, (c) a diazo resin and (d) a polymer having at least one group represented by the following formula (I), on a support having a water wettable surface: 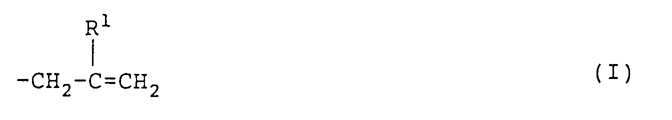 wherein R¹ represents a hydrogen atom or a methyl group.

2. The photosensitive lithographic printing plate as claimed in claim 1, wherein the photo-crosslinking polymer (a) having a maleimido group at its side chain is a polymer having a maleimido group represented by the following formula (A) at its side chain: 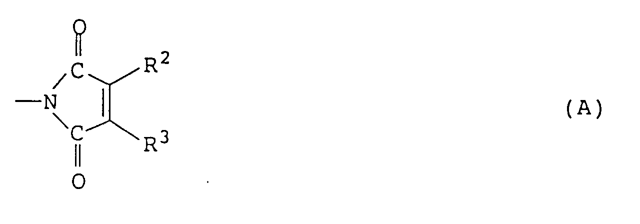 wherein R² and R³ each represents a hydrogen atom, a halogen atom, or an alkyl group; and R² and R³ may be combined with each other to form a 5-membered or 6-membered ring.

3. The photosensitive lithographic printing plate as claimed in claim 1, the diazo resin (c) has a carboxyl group in the molecule.

## Patentansprüche

1. Lichtempfindliche lithographische Druckplatte, umfassend eine lichtempfindliche Schicht, umfassend (a) ein lichtvernetzbares Polymer mit einer Maleimidgruppe in seiner Seitenkette, (b) einen Sensibilisator, (c) ein Diazoharz und (d) ein Polymer mit wenigstens einer Gruppe, die durch die folgende Formel (I) dargestellt wird, auf einem Träger mit einer wasserbenetzbaren Oberfläche: 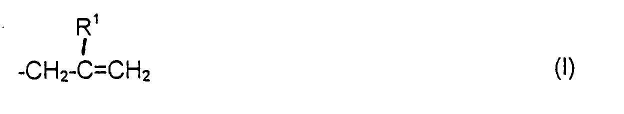 worin R¹ ein Wasserstoffatom oder eine Methylgruppe darstellt.

2. Die lichtempfindliche lithographische Druckplatte nach Anspruch 1, worin das lichtvernetzbare Polymer (a) mit einer Maleimidgruppe in seiner Seitenkette ein Polymer mit einer Maleimidgruppe, die durch die folgende Formel (A) dargestellt wird, in seiner Seitenkette ist: 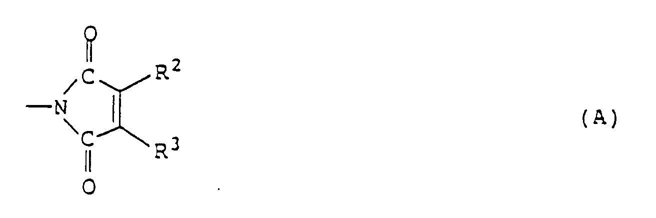 worin R² und R³ jeweils ein Wasserstoffatom, ein Halogenatom oder eine Alkylgruppe darstellen; und R² und R³ miteinander verbunden sein können, um einen 5-gliedrigen oder 6-gliedrigen Ring zu bilden.

3. Die lichtempfindliche lithographische Druckplatte nach Anspruch 1, worin das Diazoharz (c) eine Carboxylgruppe im Molekül besitzt.

## Revendications

1. Planche d'impression lithographique photosensible qui comprend une couche photosensible comprenant (a) un polymère photoréticulant ayant un groupe maléimido au niveau de sa chaîne latérale, (b) un sensibilisateur, (c) une résine diazoïque et (d) un polymère ayant au moins un groupe représenté par la formule (I) suivante, sur un support ayant une surface mouillable par l'eau: 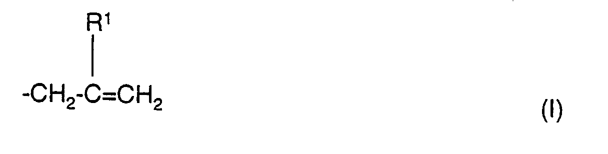 où R¹ représente un atome d'hydrogène ou un groupe méthyle.

2. Planche d'impression lithographique photosensible selon la revendication 1, dans laquelle le polymère photoréticulant (a) ayant un groupe maléimido au niveau de sa chaîne latérale est un polymère ayant un groupe maléimido représenté par la formule (A) suivante au niveau de sa chaîne latérale: 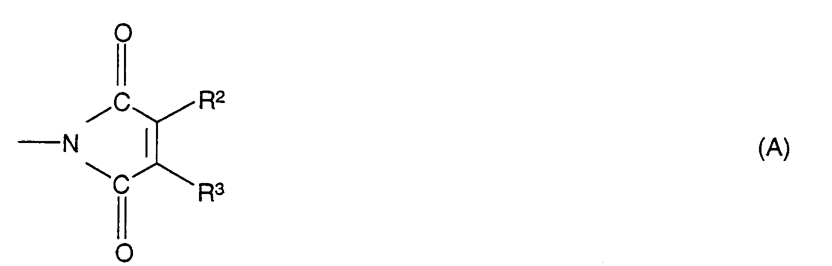 où R² et R³ représentent chacun un atome d'hydrogène, un atome d'halogène ou un groupe alkyle ; et R² et R³ peuvent être combinés l'un avec l'autre pour former un cycle à 5 ou 6 chaînons.

3. Planche d'impression lithographique photosensible selon la revendication 1, dans laquelle la résine diazoïque (c) a un groupe carboxyle dans la molécule.
